# EUROPÄISCHE PATENTSCHRIFT

(11) **EP 3 103 171 B1**
(45) Veröffentlichungstag und Bekanntmachung des Hinweises auf die Patenterteilung: **18.09.2019**
(21) Anmeldenummer: 15705901.5
(22) Anmeldetag: 28.01.2015
(51) Int. Cl.: H02B 1/30

(54) **BODENBAUGRUPPE FÜR DAS RAHMENGESTELL EINES SCHALTSCHRANKS**
FLOOR ASSEMBLY FOR THE FRAMEWORK OF AN ELECTRICAL CABINET
ENSEMBLE DE PLANCHER POUR UN CHÂSSIS D'UNE ARMOIRE ÉLECTRIQUE

(30) Priorität: 05.02.2014 DE 102014101405
(43) Veröffentlichungstag der Anmeldung: 14.12.2016
(73) Patentinhaber: RITTAL GmbH & Co. KG, 35745 Herborn (DE)
(72) Erfinder: REUTER, Wolfgang, 56479 Liebenscheid (DE); BOEHME, Siegfried, 06766 Wolfen (DE); SCHINDLER, Timo, 35649 Bischoffen (DE); BRÜCK, Daniel, 35394 Giessen (DE)
(74) Vertreter: Angerhausen, Christoph
(86) Internationale Anmeldenummer: PCT/DE2015/100035
(87) Internationale Veröffentlichungsnummer: WO 2015/117598

(56) Entgegenhaltungen:
- DE-U1- 29 509 555
- US-A- 5 380 083

## Beschreibung

Die Erfindung geht aus von einer Bodenbaugruppe für ein Rahmengestell eines Schaltschranks, mit horizontalen Rahmenprofilen der Höhe h, die einen Bodenausschnitt eines Rahmengestells umschließen, wobei die Rahmenprofile in der Höhe h eine erste horizontale Montageebene aufweisen,
wobei beabstandet von der ersten horizontalen Montageebene zumindest eine weitere Montageebene auf oder an einem Steg vorgesehen ist, der wenigstens abschnittsweise an einem oder mehreren der Rahmenprofile ausgebildet ist und der in den Bodenausschnitt ragt,
wobei eines oder mehrere der horizontalen Rahmenprofile eine Profilkammer und einen davon abgehenden Sockel mit einer Aufstandsfläche und einer Auflagefläche aufweisen,
wobei sich zumindest die Aufstandsfläche in wenigstens einer Breitenrichtung über die Breite der Profilkammer hinaus erstreckt und die Aufstandsfläche und die Auflagefläche parallel zueinander verlaufen, und
wobei in der Auflagefläche eine horizontale Montagebene liegt und die Aufstandsfläche und die Auflagefläche über eine senkrecht verlaufende Profilseite geschlossen sind. Eine derartige Bodenbaugruppe ist aus der DE 41 40 072 C2 bekannt. Eine ähnliche Bodenbaugruppe beschreibt auch die DE 295 09 555 U1.

Derartige Bodenbaugruppen sind weiterhin beispielsweise auch aus der DE 198 13 222 C1 bekannt. Von dem Rahmengestell eines Schaltschrankes ist dort der untere Teil aus horizontalen Rahmenprofilen aufgebaut, die auf einem Bodenrahmen ruhen, welcher speziell gestaltete Eckstücke hat, die wiederum Befestigungslaschen tragen, welche mit dem horizontalen Rahmenprofilen verschraubt werden. Die horizontalen Rahmenprofile weisen auf ihrer Oberseite eine Vielzahl von Befestigungsaufnahmen auf, die somit eine erste horizontale Montageebene definieren. Die Bodenbaugruppe wird durch vertikale Rahmenprofile und eine Deckenbaugruppe aus horizontalen Rahmenprofilen zu einem Rahmengestell ergänzt.

Eine weitere Bodenbaugruppe der eingangs genannten Gattung ist aus der DE 41 40 072 C2 bekannt. Dort sind horizontale Rahmenprofile und vertikale Rahmenprofile vorgesehen, die an der Vorder- und Rückseite des Rahmengestells Rahmen bilden. Diese Rahmen werden an den Ecken durch Tiefenstreben miteinander verbunden. Diese Tiefenstreben sind mehrfach abgekantet und bilden eine Struktur, die es erlaubt, dass in eine geformte Nut eine Seitenwand eingebracht werden kann. Der Führungssteg der Tiefenstreben ist mit einer Reihe von Befestigungsaufnahmen versehen und kann auch zur Anbringung von Teilen genutzt werden.

Ausgehend von diesem Stand der Technik ist es die Aufgabe der Erfindung, eine Bodenbaugruppe zur Verfügung zu stellen, die erweiterte Montagemöglichkeiten bei einfachem Aufbau hat.

Diese Aufgabe wird von einer Bodenbaugruppe nach Anspruch 1 gelöst. Vorteilhafte Ausgestaltungen sind Gegenstand der rückbezogenen Unteransprüche.

Erfindungsgemäß ist vorgesehen, dass die horizontalen Rahmenprofile Hohlprofile sind und die Auflageflächen der horizontalen Rahmenprofile Befestigungsaufnahmen aufweisen, wobei in einem Eckbereich eines Rahmengestells zwei der Rahmenprofile über ein Eckstück mit einem vertikalen Rahmenprofil verbunden sind, wobei die Rahmenprofile derart abgelängt sind, dass sie gerade auf das Eckstück treffen und bündig aneinander stoßen, so dass die weiteren Montageebenen der beiden Rahmenprofile einander entsprechen und somit die Auflagefläche des einen Rahmenprofils zu der Auflagefläche des anderen Rahmenprofils kontinuierlich fortgesetzt und ein Auflagerahmen geschaffen ist.

Vorteilhaft ist dazu vorgesehen, dass wenigstens eine der weiteren Montageebenen parallel zur ersten horizontalen Montageebene verläuft, vorzugsweise aber alle.

Weiter vorteilhaft ist der jeweilige Steg umlaufend an den horizontalen Rahmenprofilen ausgebildet, um einen kontinuierlichen Montagerahmen zur Verfügung zu stellen.

Es gibt verschiedenste Ausgestaltungsmöglichkeiten für den Steg, beispielsweise kann er durch eine Umkantung eines Profilblechs um 180 Grad gebildet sein. Da im Regelfall die Rahmenprofile Hohlprofile sind, kann auch der Steg durch mindestens eine Abkantung eines Profilbleches gebildet sein und damit selbst ein Hohlprofil darstellen. Bei beiden Varianten können am Steg zwei horizontale Montageebenen gebildet sein. Die erfindungsgemäße Bodenbaugruppe hat bei einer derartigen Ausgestaltung somit mindestens drei horizontale Montageebenen, die durch vertikale Montageebenen ergänzt werden können, wobei auch vorgesehen sein kann, dass der Steg eine vertikale Montageebene zwischen den beiden horizontalen Montageebenen aufweist.

Vorzugsweise verlaufen die horizontalen Montageebenen des Steges parallel zueinander und parallel zur ersten Montageebene.

Im Sinne des Systemgedankens ist es vorteilhaft, wenn die horizontalen Montageebenen Befestigungsaufnahmen aufweisen, beispielsweise 19" -Systemlochungen oder metrische Systemlochungen.

An zumindest einer der weiteren Montageebenen kann eine Innausbaukomponente festgelegt sein, wobei als Innenausbaukomponente Montageschienen, Chassis, Kabelführungsschienen oder dergleichen in Frage kommen. Einen besonderen Vorteil bietet die Erfindung jedoch im Zusammenhang mit einem Bodenblech als Innenausbaukomponente, das zum teilweisen oder vollständigen Verschließen des Bodenausschnitts dient.

Nach einer bevorzugten Ausführungsform ist das Bodenblech an zumindest einer seiner Seiten abgekantet, weiter bevorzugt mehrfach abgekantet, um dadurch eine höhere Stabilität zu erreichen, so dass das Bodenblech während der Montage sogar betreten werden können.

Die Flexibilität für den Ausbau der Bodengruppe wird erhöht, wenn mindestens zwei Bodenbleche vorgesehen sind, die zueinander verschieblich angebracht sind. Anstatt Ausschnitte oder Stanzungen zum Einführen von Kabeln vorzusehen, können die Bodenbleche zunächst voneinander weg bewegt werden, um einen Schlitz oder Schacht für die Kabeleinführung zu schaffen, und dann so eng wie möglich aufeinander zugeschoben werden, damit zumindest eine gute Staubdichtung erreicht wird.

Dabei kann auch vorgesehen sein, dass eines der Bodenbleche ein weiteres Bodenblech übergreift und sozusagen ein Schiebeblech bildet, das zum Beispiel mit Hilfe einer mehrfachen Abkantung auf einem Bodenblech geführt wird.

Eine besondere Ausgestaltung sieht vor, dass an mindestens zwei weiteren Montageebenen ein Bodenblech angebracht ist, wobei zwischen den Bodenblechen ein zumindest teilgeschlossener Raum gebildet wird. Damit ist eine gezielte Kabeltrennung möglich, beispielsweise zwischen Datenleitungen und Leistungskabeln.

Weiter weist das Bodenblech mindestens eine versetzbare Trennstrebe auf, die das Bodenblech unterteilt, so dass dieses für eine getrennte Sortierung von Werkzeug und Material bei der Verdrahtung im Schrank genutzt werden kann oder auch einen Reserveraum für Kabel bildet. Vorteilhaft ist das Bodenblech wannenartig gestaltet ist. Es versteht sich, dass ein solches Bodenblech in zwei Einbaurichtungen eingebaut werden kann, also als "nach oben" offene Wanne und als "nach unten" offene Wanne.

Um eine Kabelführung ohne Beschädigungen zu ermöglichen, können bei einer derartigen Wanne oder auch bei einfach abgekanteten Bodenblechseiten die Kanten gerundet sein.

Ebenfalls nach dem Systemgedanken sind für die Bodenbleche nur wenige Größen vorzuhalten, die in der Tiefe und Breite kombinierbar sind. Nach erfolgter Montage können sie durch selbstarretierende Klemmteile fixiert werden, die werkzeuglos im Raster der Systemlochung anbringbar sind.

Im Folgenden soll die Erfindung beispielhaft anhand der beigefügten Zeichnungen näher erläutert werden. Die Darstellung ist nicht notwendigerweise maßstabsgetreu, die Figuren sollen lediglich die Grundsätze der Erfindung erläutern. Es zeigt:
- Figur 1: eine Querschnittsansicht eines horizontalen Rahmenprofils gemäß einer Ausführungsform, die nicht zu der vorliegenden Erfindung gehört;
- Figur 2: eine Querschnittsansicht einer ersten Ausführungsform eines horizontalen Rahmenprofils gemäß der vorliegenden Erfindung;
- Figur 3: eine Querschnittsansicht einer zweiten Ausführungsform eines horizontalen Rahmenprofils gemäß der vorliegenden Erfindung;
- Figur 4: eine Querschnittsansicht einer vierten Ausführungsform eines horizontalen Rahmenprofils, das nicht zu der vorliegenden Erfindung gehört;
- Figur 5: eine Querschnittsansicht einer dritten Ausführungsform eines horizontalen Rahmenprofils gemäß der vorliegenden Erfindung;
- Figur 6: eine Querschnittsansicht einer vierten Ausführungsform eines horizontalen Rahmenprofils gemäß der vorliegenden Erfindung;
- Figur 7: eine perspektivische Ansicht eines Eckbereichs mit horizontalen Rahmenprofilen gemäß der Figur 6;
- Figur 8: eine perspektivische Ansicht eines horizontalen Rahmenprofils, das nicht zu der Erfindung gehört und bei dem die Profilkammer mit einer trennwandartigen Versteifungsstrebe versehen ist;
- Figur 9: eine Querschnittsansicht des Profils nach Figur 8;
- Figur 10: eine perspektivische Teilansicht eines Horizontalprofils nach Figur 3 mit montiertem Bodenblech;
- Figur 11: eine Teilansicht einer Bodenbaugruppe, die nicht zu der vorliegenden Erfindung gehört, mit verschiedenen Einbaumöglichkeiten von Bodenblechen;
- Figur 12: eine Teilansicht einer Bodenbaugruppe, die nicht zu der der vorliegenden Erfindung gehört, mit Bodenblechen, die zur Kabeleinführung vorbereitet sind;
- Figur 13: eine Variante der Bodenbaugruppe nach Figur 12;
- Figur 14: eine Teilansicht einer Bodenbaugruppe mit wannenartigen Bodenblechen, die nicht zu der Erfindung gehört; und
- Figur 15: eine Detailansicht, die die Fixierung von Bodenblechen am horizontalen Rahmenprofil einer Bodenbaugruppe zeigt, wobei die gezeigte Ausführungsform nicht Teil der Erfindung ist.

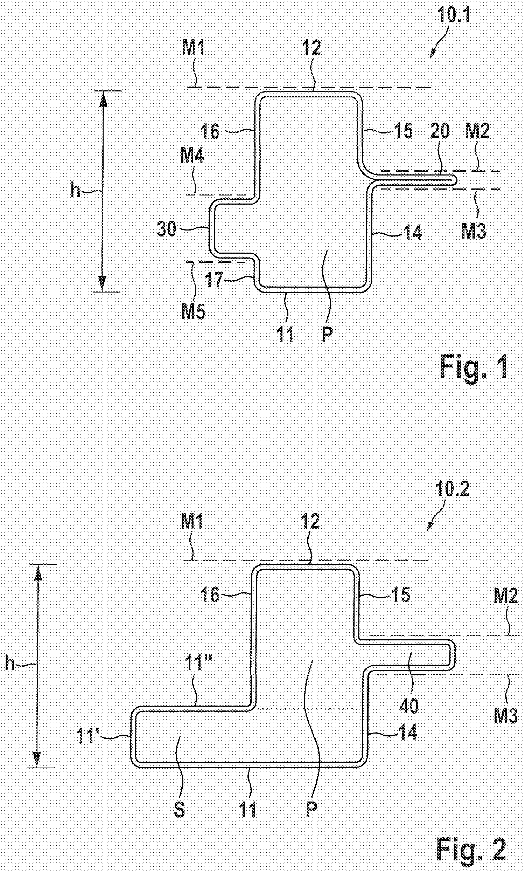

Figur 1 zeigt eine Querschnittsansicht eines horizontalen Rahmenprofils 10.1, das aus einem Blech gebogen und gestanzt ist und als Hohlprofil ausgebildet ist, wobei das horizontale Rahmenprofil 10 eine im Wesentlichen rechteckige Profilkammer P aufweist. Die Profilkammer P ist von einer ersten Profilseite 11 begrenzt, die bei bestimmungsgemäßem Einsatz des horizontalen Rahmenprofils 10 zur Bodenfläche eines Aufbaubereiches gerichtet ist und im Folgenden auch als Aufstandsfläche bezeichnet wird. Dieser ersten Profilseite 11 steht eine Profilseite 12 gegenüber, die parallel zur ersten Profilseite 10 verläuft. Die Profilseiten 11, 12 definieren die Höhe h des horizontalen Rahmenprofils 10.1. In der Profilseite 12 befinden sich Befestigungsaufnahmen (in der Figur nicht dargestellt), so dass hier eine erste horizontale Montageebene M1 definiert wird. Die Profilkammer P wird weiterhin begrenzt von einer vertikal von der Profilwand 11 abgehenden Wand 14, die in einen ersten Steg 20 übergeht, der durch eine Umkantung des Profilblechs um 180° gebildet und im Wesentlichen senkrecht zur Profilseite 14 verläuft. An den Steg 20 schließt sich, in etwa fluchtend mit der Profilseite 14, eine Profilseite 15 an, die in die Profilseite 12 mündet. Die Profilseite 12 geht wiederum in eine in etwa senkrecht dazu verlaufende Profilseite 16 über, die in einen weiteren Steg 30 mündet, der durch eine mehrfach Abkantung des Profilblechs als Hohlprofil gebildet ist und in eine Profilseite 17 übergeht, die im Wesentlichen mit der Profilseite 16 fluchtet und unter einem rechten Winkel in die Profilseite 10 mündet. Sämtliche Profilseiten 14, 15, 16, 17 können mit Befestigungsaufnahmen versehen sein, müssen es aber nicht. Mit den Stegen 20, 30 werden nun, wenn sie ebenfalls mit Befestigungsaufnahmen versehen sind, weitere horizontale Montageebenen definiert, nämlich eine Montageebene M2 und eine parallel dazu liegende Montageebene M3 auf der Ober- beziehungsweise der Unterseite des Steges 20, sowie eine horizontale Montageebene M4 und eine horizontale Montageebene M5 am Steg 30, die wiederum auf dessen Ober- beziehungsweise Unterseite gebildet sind. Alle diese horizontalen Montageebenen M2, M3, M4, M5 sind gegenüber der horizontalen Montageebene M1 "nach unten", also zur Aufstandsfläche 11 hin versetzt.

Figur 2 zeigt eine Querschnittsansicht einer Ausführungsform eines horizontalen Rahmenprofils gemäß der vorliegenden Erfindung. Ähnlich wie bei der Ausführungsform der Figur 1 ist beim horizontalen Rahmenprofil 10.2 eine erste Profilseite 11 vorgesehen, die wiederum eine Aufstandsfläche auf einer Unterlage bildet. Beabstandet dazu verläuft eine weitere Profilseite 12 im Wesentlichen parallel zu der Profilseite 11, wobei durch den Abstand der Profilseiten 11, 12 die Höhe h des horizontalen Rahmenprofils 10.2 definiert wird. Die Profilseite 12 definiert weiterhin eine erste horizontale Montageebene M1. Das horizontale Rahmenprofil 10.2 ist wiederum als Hohlprofil mit einer im Wesentlichen rechteckigen Profilkammer P ausgebildet, von der hier ein Sockel S abgeht, der eine Aufstandsfläche, nämlich die Profilseite 11, und eine Auflagefläche, nämlich die Profilseite 11", die parallel dazu verläuft, aufweist. Die Aufstandsfläche 11 und die Auflagefläche 11" sind durch eine senkrecht verlaufende Profilseite 11' geschlossen. Von der Aufstandsfläche 11 geht überdies eine Profilseite 14 ab, die in einen senkrecht zu dieser verlaufenden Steg 40 mündet, dessen Ober- beziehungsweise Unterseite jeweils eine weitere horizontale Montageebene M2 bzw. M3 definieren. Der Steg 40 ist, vergleichbar mit dem Steg 30 der Figur 1, als Hohlprofil gebildet und geht in eine Profilseite 15 über, die im Wesentlichen mit der Profilseite 14 fluchtet und unter einem rechten Winkel in die Profilseite 12 führt. Der Sockel S, der mit seiner Aufstandsfläche 11 in einer Breitenrichtung über die Breite der Profilkammer P hinausgeht, verleiht dem horizontalen Rahmenprofil 10.2 eine besondere Standfestigkeit. Es kann nichtsdestotrotz dabei vorgesehen sein, dass nicht alle horizontalen Rahmenprofile eines Rahmengestells solche beispielsweise gemäß der Ausführungsform nach Figur 2 sind, die horizontalen Rahmenprofile können auch kombiniert werden, so dass eine Bodenbaugruppe z. B. durch zwei gegenüberstehende Rahmenprofile 10.2 nach Figur 2 und durch zwei weitere, senkrecht dazu verlaufende horizontale Rahmenprofile eines anderen Typs gebildet werden kann.

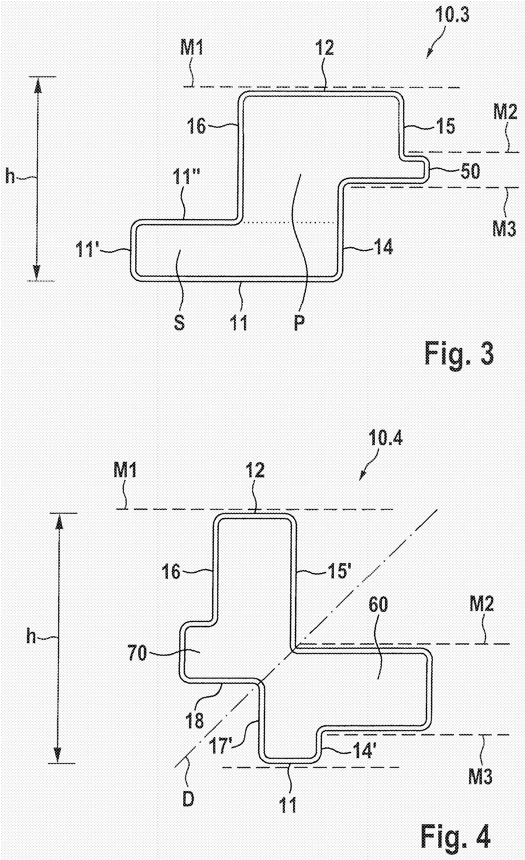

Figur 3 zeigt eine Querschnittsansicht einer weiteren Ausführungsform eines horizontalen Rahmenprofils 10.3 einer Bodenbaugruppe gemäß der vorliegenden Erfindung, die eine Variante der Ausführungsform des Rahmenprofils 10.2 nach Figur 2 darstellt. Abgeändert ist die Form der Profilkammer P, die nun nicht rechteckig, sondern im Wesentlichen rechtwinklig ist. Dazu ist die Profilseite 12 in Breitenrichtung des horizontalen Rahmenprofils 10.2 verlängert, so dass sie sich, anders als in Figur 2, über die vertikal ausgerichtete Profilseite 14 erstreckt. Demgemäß ist ein sich senkrecht zur Profilseite 14 angeordneter Steg 50 gegenüber dem Steg 40 gemäß Figur 2 verkürzt, wobei aber die horizontalen Montageebenen M2 und M3 auf der Ober- und Unterseite des Steges 50 bei geeigneter Anbringung der Befestigungsaufnahmen erhalten bleiben. Erhalten bleibt ebenso die Auflagefläche 11" als weitere horizontale Montageebene.

Abgesehen von der Bereitstellung der horizontalen Montageebenen M2, M3 können die Stege 20, 30, 40, 50 noch weitere Funktionen übernehmen, beispielsweise als Regenrinne (insbesondere der Steg 20 gemäß Figur 1) oder als Dichtkante zum Aufnehmen einer Aufsteckdichtung oder als Dichtfläche, was insbesondere für die Anreihung von Schaltschränken, die auf einer erfindungsgemäßen Bodenbaugruppe basieren, erleichtert.

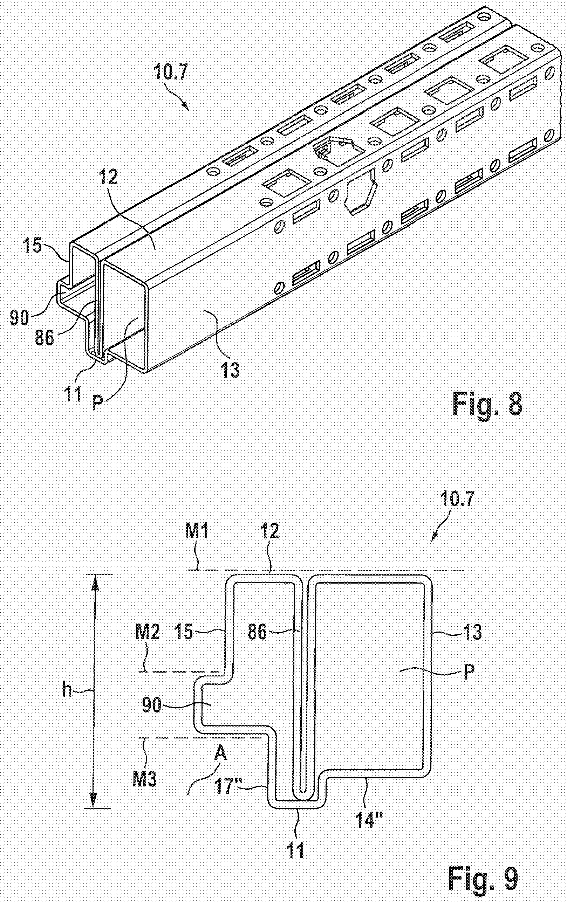

Figur 4 zeigt eine Querschnittsansicht einer usführungsform eines horizontalen Rahmenprofils 10.4 für eine Bodenbaugruppe, das wiederum als einkammriges Hohlprofil ausgebildet ist, welches aber zu einer Profildiagonalen D symmetrisch aufgebaut ist. Die Profilseite 11, die die Aufstandsfläche des horizontalen Rahmenprofils 10.4 definiert, ist kleiner als bei den Ausführungsformen nach den Figuren 1 bis 3. An diese schließt sich einerseits ein relativ kurzer Übergangsbereich 14' an, der in einen Steg 60 übergeht, durch dessen Ober- und Unterseite die horizontalen Montageebenen M2 bzw. M3 definiert sind. Andererseits geht die Profilseite 11 unter einem rechten Winkel in die Profilseite 17' und einen sich im Wesentlichen rechtwinklig daran anschließenden Stegabschnitt 18 über, der einen Teil eines Steges 70 definiert. Die Profilseite 17' und der Stegabschnitt 18 definieren einen Unterschnitt mit im Wesentlichen quadratischem Querschnitt, der zum Unterbringen von Kabeln, Leitungen und dergleichen genutzt werden kann. Dies führt zu Vorteilen insbesondere in einer Anreihsituation, bei der der Steg 70 einem gleichartigen oder ähnlichen Steg eines weiteren horizontalen Profils (beispielsweise dem Steg 90 des horizontalen Profils 10.7 gemäß Figur 9) gegenübersteht. Der Steg 70 geht über eine Profilseite 16 in die Profilseite 12 über, die durch ihren Abstand zur Profilseite 11 die Höhe h des horizontalen Rahmenprofils 10.4 definiert. Die Profilseite 15', die sich unter einem rechten Winkel an die Profilseite 12 anschließt, stößt wiederum unter einem rechten Winkel auf die horizontale Montageebene M2. Gegebenenfalls kann die Profilseite 15' Befestigungsaufnahmen aufweisen.

Bei allen bisher beschriebenen Ausführungsformen für horizontale Rahmenprofile, die bei der vorliegenden Erfindung eingesetzt werden können, sind somit vielfältigste An- und Unterbaumöglichkeiten vorgesehen, wobei bei der Bodengruppe nun auch, falls gewünscht, ein Anbauen von außen möglich ist.

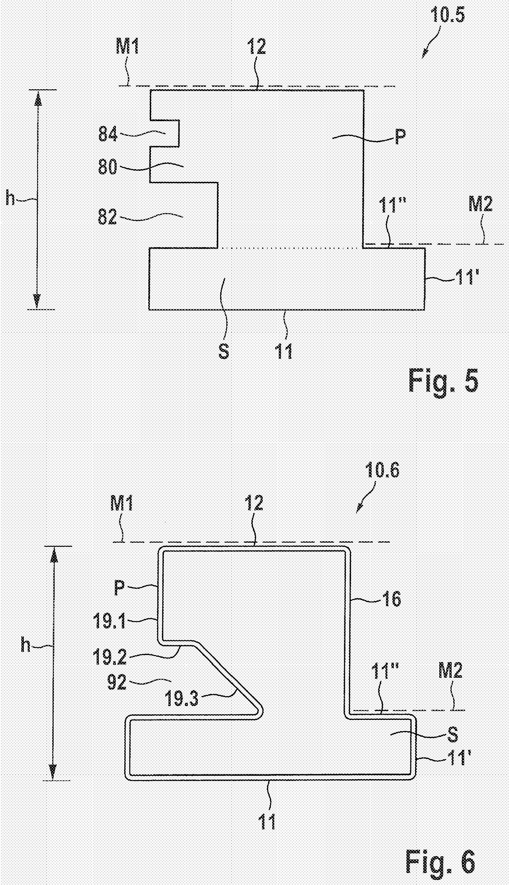

Figur 5 zeigt eine Querschnittsansicht einer weiteren Ausführungsform eines horizontalen Rahmenprofils 10.5 für eine Bodenbaugruppe gemäß der vorliegenden Erfindung. Das Rahmenprofil 10.5 ist wiederum als Hohlprofil ausgebildet, wobei sich an eine Profilkammer P ein Sockel S anschließt. Dieser Sockel bietet mit seiner Profilseite 11 ähnlich wie bei den Ausführungsformen nach den Figuren 2 und 3 eine vergrößerte Aufstandsfläche, wobei parallel zu dieser wiederum eine Auflagefläche 11" vorhanden ist, welche eine weitere horizontale Montageebene M2 definiert, die für den Innenausbau der Bodenbaugruppe genutzt werden kann. Die Aufstandsfläche 11 und die Auflagefläche 11" sind durch einen Profilabschnitt 11', der senkrecht zu diesem verläuft, miteinander verbunden. Das horizontale Rahmenprofil 10.5 weist eine Profilkammer P mit rechtwinkligem Querschnitt auf, wobei zwischen dem Sockel S und einem Ansatz 80 eine Ausnehmung 82 gebildet ist, in die beispielsweise die Abkantung eines Flachteiles, das zum Verkleiden des Rahmengestells verwendet wird, eingreifen kann. Um eine gute Staub- und Feuchtigkeitsabschottung zu gewährleisten, ist oberhalb des Ansatzes 80 eine Nut 84 eingebracht, in die eine Dichtung eingelegt, eingeklebt, eingespritzt usw. werden kann.

Eine Variante dieses Rahmenprofils ist in der Figur 6 gezeigt. Auch bei diesem als Hohlprofil ausgebildeten horizontalen Rahmenprofil 10.6 geht eine Profilkammer P in einen Sockel S über, wobei die Breite des Sockels S größer ist als die größte Breite der Profilkammer P und wobei der Sockel S in beiden Breitenrichtungen über die Profilkammer P hinausragt. Der Sockel S hat somit in der Profilseite 11 eine Aufstandsfläche, die der der Ausführungsform gemäß Figur 5 entspricht, wobei parallel zu der Aufstandsfläche 11 eine Auflagefläche 11' vorgesehen ist, die eine horizontale Montageebene M2 definiert. Aufstandsfläche 11 und Auflagefläche 11" sind durch einen Profilabschnitt 11' miteinander verbunden. Die Auflagefläche 11" geht in eine rechtwinklig dazu verlaufenden Profilseite 16 über, die sich in die Profilseite 12 fortsetzt, welche die erste horizontale Montageebene M1 definiert. An die Profilseite 12 schließt sich senkrecht dazu verlaufend ein erster Profilseitenabschnitt 19.1 , senkrecht dazu ein zweiter Profilseitenabschnitt 19.2 und schräg, unter einem Winkel von etwas 135° zum Profilseitenabschnitt 19.2 verlaufend, ein dritter Profilseitenabschnitt 19.3 an, der in die Oberseite des Sockels S mündet. Somit wird auch hier eine Ausnehmung 92 gebildet, in die eine Abkantung eines Flachteiles eingelegt werden kann. Ist eine Dichtung gewünscht, kann diese auf den Profilseitenabschnitt 19.1 aufgespritzt werden.

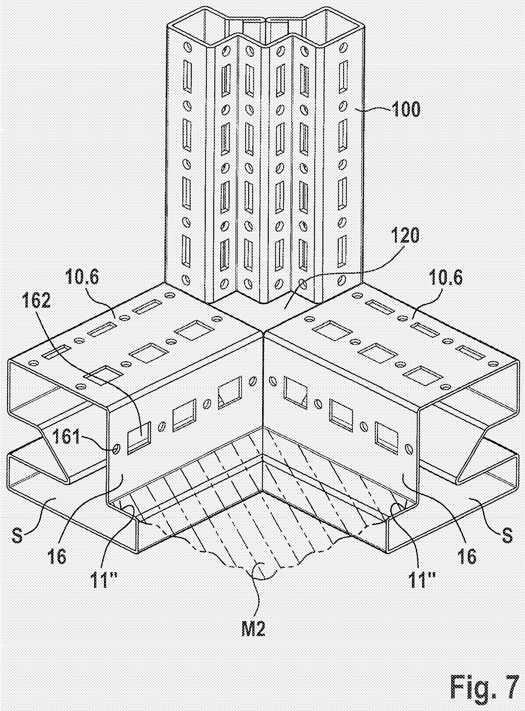

Figur 7 zeigt den Eckbereich eines Rahmengestells, bei dem horizontale Rahmenprofile gemäß der Ausführungsform nach Figur 6 für die Bodenbaugruppe verwendet werden. Die beiden horizontalen Rahmenprofile 10.6 sind mit einem vertikalen Rahmenprofil 100 über ein Eckstück 120 verbunden, was hier nicht näher beschrieben werden soll. Vertikale Rahmenprofile und Eckstücke in bekannter Ausgestaltung sind geeignet. Die horizontalen Rahmenprofile 10.6 sind bei dem gezeigten Beispiel derart abgelängt, dass sie gerade auf das Eckstück 120 treffen und bündig aneinander stoßen, so dass insbesondere die horizontalen Montageebenen M2 beider Rahmenprofile 10.6 einander entsprechen. Somit wird durch die kontinuierliche Fortsetzung der Auflagefläche 11" von einem der horizontalen Rahmenprofile 10.6 zu einem anderen ein Auflagerahmen geschaffen, der für den Innenausbau eines Rahmengestells im Bodenbereich genutzt werden kann. Zusätzlich sind hier beispielhaft in die Profilseiten 16 Befestigungsaufnahmen 161, 162 eingebracht, die der üblichen Systemlochung eines Rahmenprofils entsprechen und die zum Anbringen einer Innenausbaukomponente, beispielsweise eine Montageschiene, eines Chassis, einer Kabelführungsschiene oder dergleichen und auch von Bodenblechen verwendet werden.

Diese Innenausbaumöglichkeiten werden auch von den bisher beschriebenen Profilgeometrien und von der nach den Figuren 8 und 9 zur Verfügung gestellt, soweit die entsprechenden Befestigungsaufnahmen vorhanden sind.

Figur 8, die im Zusammenhang mit der Figur 9 betrachtet werden sollte, zeigt eine perspektivische Ansicht eines weiteren horizontalen Rahmenprofils 10.7, das für Einsatzwecke besonders geeignet ist, bei denen es auf die Belastungsfestigkeit des Rahmenprofils ankommt. Die Profilkammer P des horizontalen Rahmenprofils 10.7 ist über seine Länge durch eine in Höhenrichtung verlaufende Versteifungsstrebe 86 geteilt, die sich bis auf die Profilseite 11 erstreckt, die die Aufstandsfläche des Rahmenprofils 10.7 bildet.

Die Profilgeometrie des horizontalen Rahmenprofils 10.7 ist besser aus der Querschnittdarstellung der Figur 9 erkennbar. Das Profilblech der Profilseite 12 ist mit einer Umkantung um 180° in die Profilkammer P gezogen, so dass eine Versteifungsstrebe 86 aus doppelt gelegtem Profilblech entsteht, die sich auf der Profilseite 11 abstützt. Auf diese Weise wird erreicht, dass selbst bei starker Belastung der Profilseite 12 keine Verformungen der Profilgeometrie auftreten. Die Anbringungsmöglichkeiten in der Montageebene aus M1 können damit auch für schwere Lasten voll ausgenutzt werden. An die Profilseite 12 schließt sich, senkrecht dazu verlaufend, eine Profilseite 1 an, die in einen Steg 90 mündet, dessen Ober- und Unterseite horizontal verlaufende Montageebenen M2 bzw. M3 definieren. Unterhalb des Steges 90 ist, ähnlich wie bei der Ausgestaltung der Figur 4, eine Ausnehmung A zwischen der Montageebene M3 und dem rechtwinklig anschließenden Profilseitenabschnitt 17" vorgesehen, in der Kabel, Leitungen und Dergleichen geführt werden können, wobei hier auch durch in der Montageebene M3 vorgesehene Befestigungsaufnahmen (nicht gezeigt) eine Fixierung der Kabel oder Leitungen erfolgen kann, beispielsweise durch Clips, die in den Befestigungsaufnahmen verrastet werden. Die Profilseite 11 geht über einen Stufenabschnitt 14" in eine Profilseite 13 über, die die Außenseite des horizontalen Rahmenprofils 10.7 darstellt.

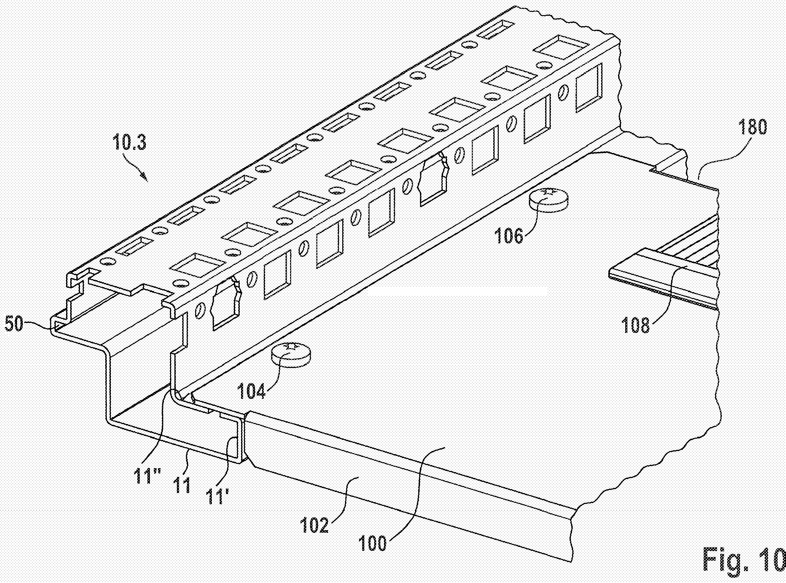

Figur 10 zeigt eine perspektivische Teildarstellung einer Bodenbaugruppe gemäß der vorliegenden Erfindung, bei der das horizontale Rahmenprofil 10.3 gemäß Figur 3 verwendet wird, hier im Zusammenhang mit einem Bodenblech 100, das den Bodenausschnitt 180 eines Rahmengestells zumindest teilweise verschließt.

Das Bodenblech 100 weist eine Abkantung 102 auf, deren Länge der Höhe des Profilabschnitts 11' des horizontalen Rahmenprofils 10.3 entspricht, so dass sich insgesamt ein bündiger Abschluss mit der Profilseite 11 als Aufstandsfläche ergibt. Das Bodenblech 100 ist mittels zweier Schrauben 104, 106 in Befestigungsaufnahmen der Auflagefläche 11" festgelegt, und das Bodenblech 100 weist weiterhin eine Ausnehmung (nicht gezeigt) auf, in der eine Bürstenleiste 108 angebracht ist, um eine Kabelzuführung von unterhalb des Bodenblechs 100 her zu ermöglichen. Die Gestaltung der horizontalen Rahmenprofile gemäß der vorliegenden Erfindung, wie sie beispielhaft zuvor beschrieben sind, ermöglichen somit die direkte Montage von Bodenblechen am Profil, ohne dass ein Bodenrahmen oder eine Bodenwanne erforderlich wäre.

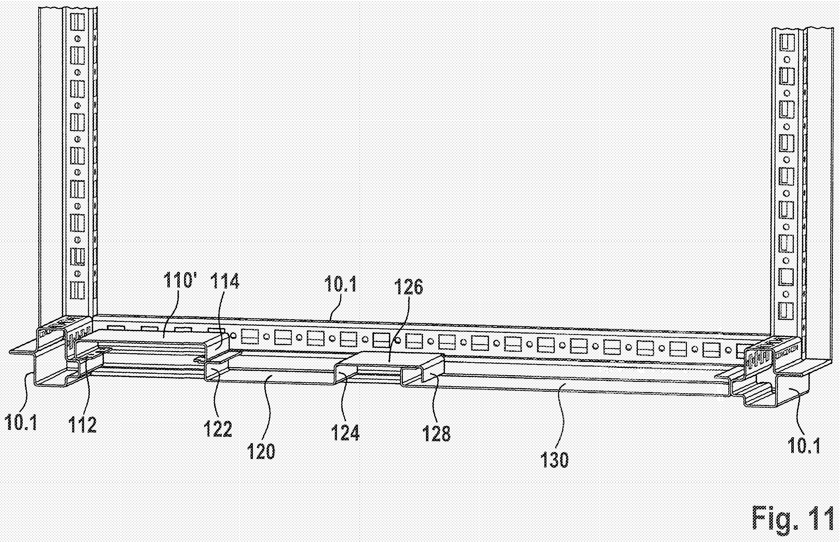

Bodenplatten oder Bodenbleche können vielfältig gestaltet sein, wie das Beispiel der Figur 11 zeigt. Bei der dort dargestellten Ausführungsform eines Rahmengestells werden horizontale Rahmenprofile 10.1 gemäß der Ausführungsform nach Figur 1 verwendet. Hier wird der Steg 20 mit seinen Befestigungsmöglichkeiten nicht genutzt, jedoch der Steg 30, der die Montageebenen M4 und M5 (Figur 1) definiert.

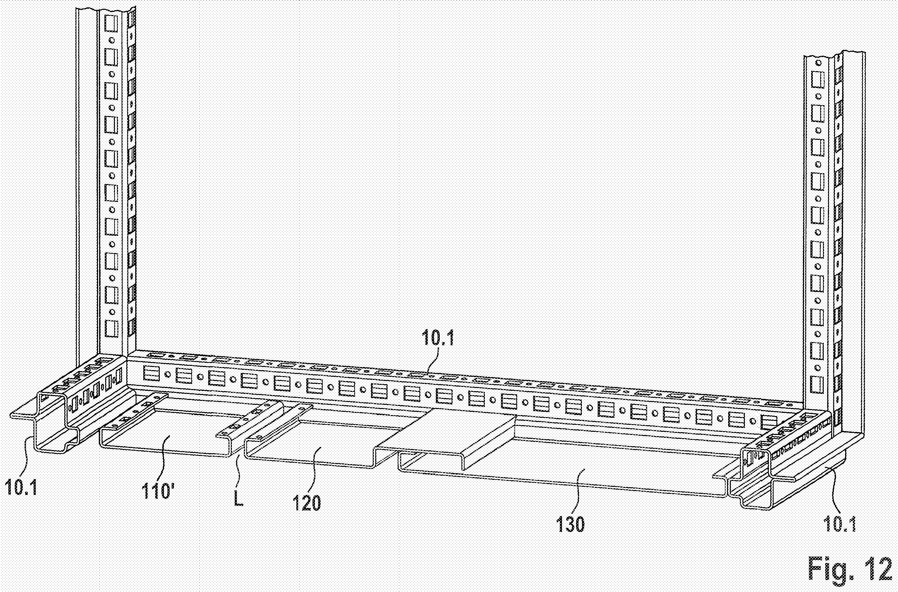

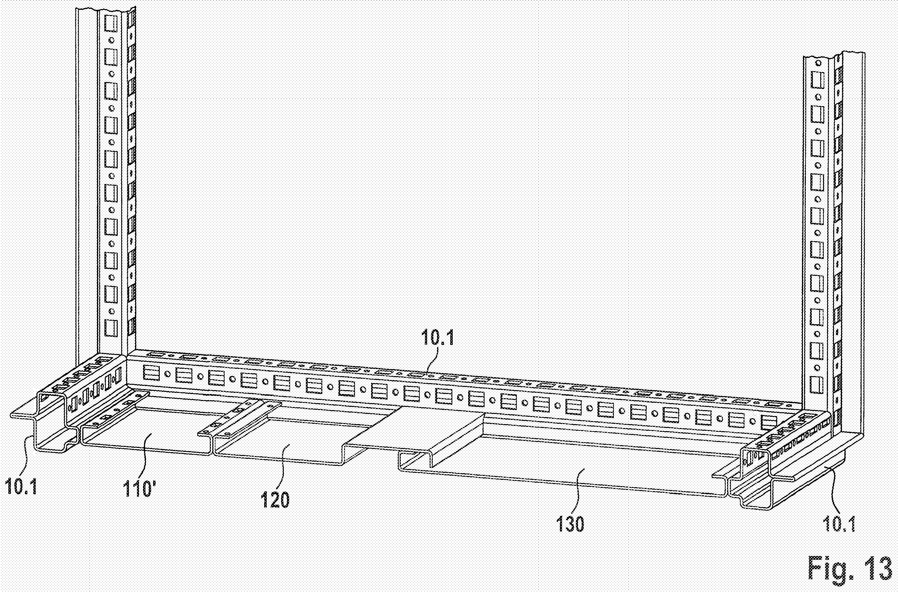

Bei der Anordnung der Figur 11 wird ersichtlich, wie Bodenbleche 110, 120, 130 in verschiedenen Ebenen eingerichtet werden können. Die Bodenplatte 110, die an zwei gegenüberliegenden Seiten mit einer mehrfachen Abkantung 112, 114 versehen ist, ruht mit ihrem freien Ende auf der Montageebene M4 und bildet so einen Freiraum, der zur Kabeleinführung und auch zur Kabeltrennung bei unterschiedlichen Leistungsarten eingesetzt werden kann. Als Alternative kann auch ein weiteres Bodenblech nach Art einer Wanne, also sozusagen "umgedreht" mit seiner flachen Abkantung in der Montageebene M5 festgelegt werden, so dass ein zumindest teilgeschlossener Raum zwischen den Bodenblechen gebildet wird. Durch die tragblechartige Ausgestaltung der Bodenbleche 110 ist also ein variabler Einbau möglich. Ein weiteres Bodenblech 120 weist an einem freien Ende eine doppelte Abkantung 122 auf, der eine einfache Abkantung 124 beabstandet gegenübersteht, die sich in einer stufenartig erhöhten Fläche 126 fortsetzt. Zusammen mit einer einfachen Abkantung 128 ergibt sich somit ein Bereich des Bodenbleches 120, der verschieblich auf das Bodenblech 130 gesetzt werden kann, und dabei in seiner Verschiebebewegung durch die Abkantungen 124 und 128 begrenzt ist. Durch diese Ausgestaltung, die besser aus einer Zusammenschau der Figuren 12 und 13 hervorgeht, kann zum Beispiel eine Lücke L zwischen dem Bodenblech 110' und dem Bodenblech 120 erzeugt werden, indem das Bodenblech 120 über das Bodenblech 130 geschoben wird. Durch diese Lücke L können Kabel eingeführt werden, anschließend wird das Bodenblech 120 in Richtung auf das Bodenblech 110' bewegt, so dass die Lücke L sehr klein gehalten werden kann, was auch das Eindringen von Schmutz und Feuchtigkeit verhindert.

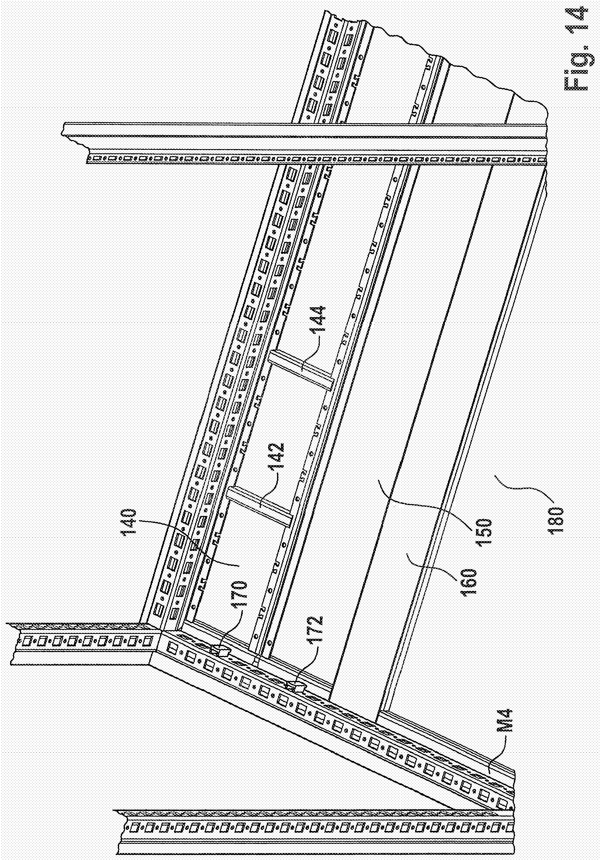

Figur 14 zeigt eine Kombination von zwei sich in Richtung eines horizontalen Rahmenprofils 10.1 erstreckender Bodenbleche 140, 150, die an ihrer seitlichen Verschiebbarkeit durch ein Abschlussteil 160 gehindert sind und teilweise den Bodenausschnitt 180 einer Bodenbaugruppe abdecken. Die Bodenbleche 140, 150 und das Abschlussteil 160 sind in der Montageebene M4 fixiert. Das Bodenblech 140 weist Trennstreben 142, 144 auf, die an unterschiedlichen Positionen des Bodenbleches 140 fixiert werden können, wozu geeignete Befestigungsaufnahmen an Abkantungen des Bodenbleches 140 vorgesehen sind. Wenn diese Fixierung beispielsweise durch einfaches Einhängen geschieht, können die Trennstreben 142, 144 jederzeit nach Bedarf neu positioniert werden und schaffen so zum Beispiel voneinander getrennte Ablageflächen, auch für Kabel, das zur Zeit nicht benötigt wird.

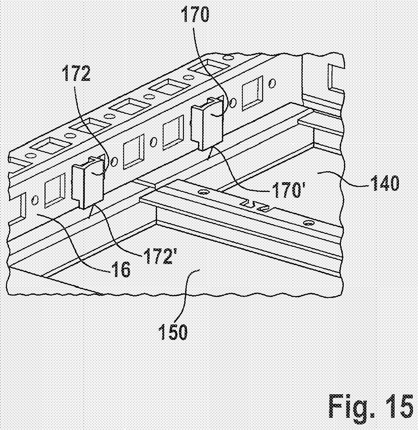

Die Befestigung der Bodenbleche 140, 150 geschieht mit Hilfe von einrastbaren, selbstarretierenden Klemmteilen 170, 172, wie es am Besten in Figur 15 zu erkennen ist. Die Klemmteile 170, 172 werden in Befestigungsaufnahmen der Systemlochrasterung eines horizontalen Rahmenprofiles, die in einer vertikalen Profilseite 16 vorhanden sind, eingesteckt und liegen mit einer Anlageseite 170', 172' auf den Abkantungen der Bodenbleche 140, 150 auf. Dies erlaubt eine werkzeuglose Montage, so dass Umrüstarbeiten einfach zu bewerkstelligen sind.

## Patentansprüche

1. Bodenbaugruppe für ein Rahmengestell eines Schaltschranks, mit horizontalen Rahmenprofilen der Höhe h, die einen Bodenausschnitt (180) eines Rahmengestells umschließen, wobei die Rahmenprofile in der Höhe h eine erste horizontale Montageebene (M1) aufweisen,
wobei beabstandet von der ersten horizontalen Montageebene (M1) zumindest eine weitere Montageebene (M2, M3, M4, M5, 11") auf oder an einem Steg (40,50) vorgesehen ist, der wenigstens abschnittsweise an einem oder mehreren der Rahmenprofile (10.2, 10.3, 10.5, 10.6) ausgebildet ist und der in den Bodenausschnitt (180) ragt,
wobei eines oder mehrere der horizontalen Rahmenprofile (10.2, 10.3, 10.5, 10.6) eine Profilkammer (P) und einen davon abgehenden Sockel (S) mit einer Aufstandsfläche (11) und einer Auflagefläche (11") aufweisen,
wobei sich zumindest die Aufstandsfläche (11) in wenigstens einer Breitenrichtung über die Breite der Profilkammer (P) hinaus erstreckt und die Aufstandsfläche (11) und die Auflagefläche (11") parallel zueinander verlaufen, und
wobei in der Auflagefläche (11") eine horizontale Montagebene liegt und die Aufstandsfläche (11) und die Auflagefläche (11") über eine senkrecht verlaufende Profilseite (11') geschlossen sind,
**dadurch gekennzeichnet, dass** die horizontalen Rahmenprofile (10.2, 10.3, 10.5, 10.6) Hohlprofile sind und die Auflageflächen (11") der horizontalen Rahmenprofile (10.6) Befestigungsaufnahmen aufweisen, wobei in einem Eckbereich eines Rahmengestells zwei der Rahmenprofile (10.6) über ein Eckstück (120) mit einem vertikalen Rahmenprofil (100) verbunden sind, wobei die Rahmenprofile (10.6) derart abgelängt sind, dass sie gerade auf das Eckstück (120) treffen und bündig aneinander stoßen, so dass die weiteren Montageebenen (M2) der beiden Rahmenprofile (10.6) einander entsprechen und somit die Auflagefläche (11") des einen Rahmenprofils (10.6) zu der Auflagefläche (11") des anderen Rahmenprofils (10.6) kontinuierlich fortgesetzt und ein Auflagerahmen geschaffen ist.

2. Bodenbaugruppe nach Anspruch 1, **dadurch gekennzeichnet, dass** wenigstens eine der weiteren Montageebenen (M2, M3, M4, M5, 11") parallel zur ersten horizontalen Montageebene (M1) verläuft.

3. Bodenbaugruppe nach Anspruch 1, **dadurch gekennzeichnet, dass** der Steg (40, 50) umlaufend an den horizontalen Rahmenprofilen (10.2, 10.3, 10.5, 10.6) ausgebildet ist.

4. Bodenbaugruppe nach Anspruch 1, **dadurch gekennzeichnet, dass** der Steg (40,50) durch eine Umkantung eines Profilblechs um 180° gebildet ist.

5. Bodenbaugruppe nach Anspruch 1, **dadurch gekennzeichnet, dass** der Steg (40,50) durch mindestens eine Abkantung eines Profilblechs als Hohlprofil gebildet ist.

6. Bodenbaugruppe nach Anspruch 1, **dadurch gekennzeichnet, dass** am Steg zwei horizontale Montageebenen (M2, M3, M4, M5) gebildet sind.

7. Bodenbaugruppe nach Anspruch 6, **dadurch gekennzeichnet, dass** die horizontalen Montageebenen (M2, M3, M4, M5) des Steges parallel zueinander und parallel zur ersten Montageebene (M1) verlaufen.

8. Bodenbaugruppe nach Anspruch 1, **dadurch gekennzeichnet, dass** die horizontalen Montageebenen (M2, M3, M4, M5, 11") Befestigungsaufnahmen aufweisen.

9. Bodenbaugruppe nach Anspruch 1, **dadurch gekennzeichnet, dass** an zumindest einer der weiteren Montageebenen eine Innenausbaukomponente (100, 110, 120, 130, 140, 150, 160) festgelegt ist.

10. Bodenbaugruppe nach Anspruch 9, **dadurch gekennzeichnet, dass** die Innenausbaukomponente eine Montageschiene, ein Chassis, eine Kabelführungsschiene oder dergleichen ist.

11. Bodenbaugruppe nach Anspruch 9, **dadurch gekennzeichnet, dass** die Innenausbaukomponente ein Bodenblech (100, 110, 120, 130, 140, 150) zum teilweisen oder vollständigen Verschließen des Bodenausschnitts ist.

12. Bodenbaugruppe nach Anspruch 11, **dadurch gekennzeichnet, dass** das Bodenblech (100, 110, 120, 130, 140, 150) an zumindest einer seiner Seiten abgekantet ist.

13. Bodenbaugruppe nach Anspruch 11 oder 12, **dadurch gekennzeichnet, dass** mindestens zwei Bodenbleche (120, 130) vorgesehen sind, die zueinander verschieblich angebracht sind.

14. Bodenbaugruppe nach Anspruch 13, **dadurch gekennzeichnet, dass** eines der Bodenbleche (120) ein weiteres Bodenblech (130) übergreift.

15. Bodenbaugruppe nach Anspruch 11, **dadurch gekennzeichnet, dass** an mindestens zwei weiteren Montageebenen (M2, M3, M4, M5) ein Bodenblech angebracht ist, wobei zwischen den Bodenblechen ein zumindest teilgeschlossener Raum gebildet ist.

16. Bodenbaugruppe nach Anspruch 11, **dadurch gekennzeichnet, dass** das Bodenblech (140) mindestens eine versetzbare Trennstrebe (142, 144) aufweist, die das Bodenblech (140) unterteilt.

17. Bodenbaugruppe nach Anspruch 11 oder 12, **dadurch gekennzeichnet, dass** das Bodenblech (140, 150) wannenartig ausgebildet sein.

## Claims

1. A base assembly for a rack of a switchgear cabinet, comprising horizontal frame profiles which have the height h and which surround a base section (180) of the rack, wherein at the height h, the frame profiles have a first horizontal mounting plane (M1),
wherein, spaced from the first horizontal mounting plane (M1), at least one additional mounting plane (M2, M3, M4, M5, 11") is provided, on or adjoining a fixed support (40, 50) which is formed at least sectionally on one or more of the frame profiles (10.2, 10.3, 10.5, 10.6) and projects into the base section (180),
wherein one or more of the horizontal frame profiles (10.2, 10.3, 10.5, 10.6) has a profile chamber (P) with a base (S) protruding therefrom, which has a standing surface (11) and a bearing surface (11"),
wherein at least the standing surface (11) extends beyond the width of the profile chamber (P) in at least one widthwise direction and the standing surface (11) and the bearing surface (11") extend parallel to one another, and
wherein a horizontal mounting plane (11") is located on the bearing surface (11"), and the standing surface (11) and the bearing surface (11") are connected to one another via a perpendicularly extending profile side (11'),
**characterized in that** the horizontal frame profiles (10.2, 10.3, 10.5, 10.6) are hollow profiles and the standing surfaces (11") of the horizontal frame profiles (10.6) have fastening receptacles, wherein two of the frame profiles (10.6) are joined in a corner region of a rack to a vertical frame profile (100) by means of acorner piece (120), wherein the frame profiles (10.6) are cut to length such that they meet at the corner piece (120) and abut flush with one another, so that the additional mounting planes (M2) of the two frame profiles (10.6) are aligned with one another, and thus the bearing surface (11") of one frame profile (10.6) is extended continuously to the bearing surface (11") of the other frame profile (10.6), creating a bearing frame.

2. The base assembly according to claim 1, **characterized in that** at least oneof the additional mounting planes (M2, M3, M4, M5, 11") extends parallel to the first horizontal mounting plane (M1).

3. The base assembly according to claim 1, **characterized in that** the fixed support (40, 50) is formed on the horizontal frame profiles (10.2, 10.3, 10.5, 10.6,) around the entire base perimeter.

4. The base assembly according to claim 1, **characterized in that** the fixed support (20) is formed by a profile sheet that is folded over 180°.

5. The base assembly according to claim 1, **characterized in that** the fixed support (40, 50) is formed as a hollow profile by at least one bend in a profile sheet.

6. The base assembly according to claim 1, **characterized in that** two horizontal mounting planes (M2, M3, M4, M5) are formed on the fixed support.

7. The base assembly according to claim 6, **characterized in that** the horizontal mounting planes (M2, M3, M4, M5) of the fixed support extend parallel to one another and parallel to the first mounting plane (M1).

8. The base assembly according to claim 1, **characterized in** tha the horizontal mounting planes (M2, M3, M4, M5, 11") have fastening receptacles.

9. The base assembly according to claim 1, **characterized in that** an interior fitting component (100, 110, 120, 130, 140, 150, 160) is secured in at least one of the additional mounting planes.

10. The base assembly according to claim 9, **characterized in that** the interior fitting component is a mounting rail, a chassis, a cable routing track or the like.

11. The base assembly according to claim 9, **characterized in that** the interior fitting component is a base plate (100, 110, 120, 130, 140, 150) for partially or completely covering the base section.

12. The base assembly according to claim 11, **characterized in that** the base plate (100, 110, 120, 130, 140, 150) is bent along at least one of its sides.

13. The base assembly according to claim 11 or 12, **characterized in that** at least two base plates (120, 130) are provided, slidably attached to one another.

14. The base assembly according to claim 13, **characterized in that** one of the base plates (120) extends over another base plate (130).

15. The base assembly according to claim 11, **characterized in that** base plates are attached in at least two additional mounting planes (M2, M3, M4, M5), forming an at least partially enclosed space between the base plates.

16. The base assembly according to claim 11, **characterized in that** the base plate (140) has at least one relocatable divider brace (142, 144) that subdivides the base plate (140).

17. The base assembly according to claim 11 or 12, **characterized in that** the base plate (140, 150) may be in the form of a tray.

## Revendications

1. Sous-ensemble de fond pour un châssis d'une armoire de commande, avec des profilés de châssis horizontaux d'une hauteur h, qui entourent une découpe de fond (180) d'un châssis, les profilés de châssis de hauteur h comprenant un premier plan de montage horizontal (M1),
moyennant quoi, éloigné du premier plan de montage horizontal (M1), est prévu au moins un autre plan de montage (M2, M3, M4, M5, 11") sur ou au niveau d'une nervure (40, 50), qui est réalisée au niveau d'un ou plusieurs des profilés de châssis (10.2, 10.3, 10.5, 10.6) et qui dépasse dans la découpe de fond (180),
un ou plusieurs des profilés de châssis horizontaux (10.2, 10.3, 10.5, 10.6) comprennent une chambre de profilé (P) et un socle (S) partant de celle-ci, avec une surface de contact (11) et une surface d'appui (11"),
au moins la surface de contact (11) s'étendant dans au moins une direction de largeur sur la largeur au-delà de la chambre de profilé (P) et la surface de contact (11) et la surface d'appui (11") s'étendant parallèlement entre elles et
dans la surface d'appui (11"), se trouve un plan de montage horizontal et la surface de contact (11) et la surface d'appui (11") sont fermés par un côté de profilé (11') s'étendant perpendiculairement,
**caractérisé en ce que** les profilés de châssis horizontaux (10.2, 10.3, 10.5, 10.6) sont des profilés creux et les surfaces d'appui (11") des profilés de châssis horizontaux (10.6) comprennent des logements de fixation, moyennant quoi, dans une zone d'angle d'un châssis, deux des profilés de châssis (10.6) sont reliés par l'intermédiaire d'un élément d'angle (120) avec un profilé de châssis vertical (100), les profilés de châssis (10.6) étant coupés à la longueur de façon à ce qu'ils arrivent droit sur l'élément d'angle (120) et entrent en contact entre eux de manière affleurante, de façon à ce que les autres plans de montage (M2) des deux profilés de châssis (10.6) correspondent entre eux, à ce que la surface d'appui (11") d'un profilé de châssis (10.6) se prolonge de manière continue vers la surface d'appui (11") de l'autre profilé de châssis (10.6) et à ce qu'un logement d'appui soit ainsi créé.

2. Sous-ensemble de fond selon la revendication 1, **caractérisé en ce qu'**au moins un des autres plans de montage (M2, M3, M4, M5, 11") s'étend parallèlement au premier plan de montage horizontal (M1).

3. Sous-ensemble de fond selon la revendication 1, **caractérisé en ce que** la nervure (40, 50) est réalisée de manière périphérique au niveau des profilés de châssis horizontaux (10.2, 10.3, 10.5, 10.6).

4. Sous-ensemble de fond selon la revendication 1, **caractérisé en ce que** la nervure (40, 50) est constituée d'un repli d'une tôle profilée de 180°.

5. Sous-ensemble de fond selon la revendication 1, **caractérisé en ce que** la nervure (40, 50) est constituée d'au moins un pliage d'une tôle profilée sous la forme d'un profilé creux.

6. Sous-ensemble de fond selon la revendication 1, **caractérisé en ce que**, sur la nervure sont formés deux plans de montage horizontaux (M2, M3, M4, M5).

7. Sous-ensemble de fond selon la revendication 6, **caractérisé en ce que** les plans de montage horizontaux (M2, M3, M4, M5) de la nervure s'étendent parallèlement entre eux et parallèlement au premier plan de montage (M1).

8. Sous-ensemble de fond selon la revendication 1, **caractérisé en ce que** les plans de montage horizontaux (M2, M3, M4, M5, 11") comprennent des logements de fixation.

9. Sous-ensemble de fond selon la revendication 1, **caractérisé en ce que**, sur au moins un des autres plans de montage, est fixé un composant d'aménagement intérieur (100, 112, 120, 130, 140, 150, 160).

10. Sous-ensemble de fond selon la revendication 9, **caractérisé en ce que** le composant d'aménagement intérieur est un rail de montage, un châssis, un rail de guidage de câbles ou autre.

11. Sous-ensemble de fond selon la revendication 9, **caractérisé en ce que** le composant d'aménagement intérieur est une tôle de fond (100, 112, 120, 130, 140, 150) pour l'obturation partielle ou complète de la découpe de fond.

12. Sous-ensemble de fond selon la revendication 11, **caractérisé en ce que** la tôle de fond (100, 112, 120, 130, 140, 150) est repliée au niveau d'au moins un de ses côtés.

13. Sous-ensemble de fond selon la revendication 11 ou 12, **caractérisé en ce qu'**au moins deux tôles de fond (120, 130) sont prévues, qui sont montées de manière coulissante entre elles.

14. Sous-ensemble de fond selon la revendication 13, **caractérisé en ce qu'**une des tôles de fond (120) vient en prise sur une autre tôle de fond (130).

15. Sous-ensemble de fond selon la revendication 11, **caractérisé en ce que**, au niveau d'au moins deux autres plans de montage (M2, M3, M4, M5), est montée une tôle de fond, moyennant quoi un espace au moins partiellement fermé est formé entre les tôles de fond.

16. Sous-ensemble de fond selon la revendication 11, **caractérisé en ce que** la tôle de fond (140) comprend au moins une entretoise de séparation mobile (142, 144) qui divise la tôle de fond (140).

17. Sous-ensemble de fond selon la revendication 11 ou 12, **caractérisé en ce que** la tôle de fond (140, 150) est conçue sous la forme d'une cuve.
